# EUROPÄISCHE PATENTANMELDUNG

(11) **EP 3 754 702 A1**
(43) Veröffentlichungstag der Anmeldung: **23.12.2020**
(21) Anmeldenummer: 19181328.6
(22) Anmeldetag: 19.06.2019
(51) Int. Cl.: H01L 23/473

(54) **VERFAHREN ZUM HERSTELLEN EINES KÜHLKÖRPERS**

(71) Anmelder: Siemens Aktiengesellschaft, 80333 München (DE)
(72) Erfinder: Rehme, Olaf, 20148 Hamburg (DE)

(57) **Zusammenfassung**

Die Erfindung betrifft ein Verfahren zum Herstellen eines Kühlkörpers (10) und einen Kühlkörper (10). Um einen Kühlkörper (10) aus einem thermisch sowie elektrisch gut leitenden Material (M1) zu fertigen und gleichzeitig eine ausreichende Korrosionsbeständigkeit sicherzustellen werden die Schritte vorgeschlagen:
- Bereitstellen (S1) eines Grundkörpers (100) aus einem ersten Material (M1) aufweisend ein oder mehrere Kühlkanäle (110),
- Aufbringen (S2) einer ersten Schicht (111) eines zweiten Materials (M2) auf eine Oberfläche (115) der Kühlkanäle (110),
- Einbringen (S3) eines Füllstoffs (130), sodass dieser als Stützmaterial für eine zweite Schicht (112) dient,
- Aufbringen (S4) der zweiten Schicht (112) des zweiten Materials (M2), sodass sich ein oder mehrere geschlossene Kanäle (125) aus der ersten Schicht (111) und der zweiten Schicht (112) in den Kühlkanälen (110) bilden und
- Aufbringen (S5) einer Deckschicht (150) auf die geschlossenen Kanäle (125).

## Beschreibung

Die Erfindung betrifft ein Verfahren zum Herstellen eines Kühlkörpers sowie einen Kühlkörper. Der so hergestellte Kühlkörper eignet sich insbesondere für Leistungshalbleiter, insbesondere für Thyristoren. Diese Leistungshalbleiter sind Komponenten, die in stromführende Bereiche eingebracht werden und gute elektrische Leitfähigkeit aufweisen müssen. Gleichzeitig werden sie von einer Kühlflüssigkeit durchflossen. Hier kommt insbesondere deionisiertes Kühlwasser zum Einsatz, um eine Leitfähigkeit des Wassers und damit die Gefahr eines Kurzschlusses zu vermeiden. Aus Sicht der thermischen und elektrischen Leitfähigkeit ist es oft attraktiv den Kühlkörper aus einem elektrisch und thermisch gut leitenden Material, z. B. Kupfer herzustellen. Diese Materialien sind oft nicht korrosionsbeständig, was gerade beim Einsatz von korrosiven Kühlflüssigkeiten, wie deionisiertem Wasser, wichtig ist.

Der Kühlkörper ist auch für weitere Leistungselektronik vorteilhaft und kann beispielsweise auch für MOSFETs, IGBTs, Dioden und GTOs zum Einsatz kommen.

Es ist nun Aufgabe der Erfindung, ein Verfahren anzugeben, das es ermöglicht, einen Kühlkörper aus einem thermisch sowie elektrisch gut leitenden Material zu fertigen und gleichzeitig eine ausreichende Korrosionsbeständigkeit sicherzustellen.

Die Aufgabe wird gelöst durch ein Verfahren zum Herstellen eines Kühlkörpers für Leistungshalbleiter, insbesondere für Thyristoren. Das Verfahren umfasst dabei die im Folgenden aufgezeigten Schritte.

Bereitstellen eines Grundkörpers aus einem ersten Material, wobei der Grundkörper ein oder mehrere Kühlkanäle aufweist.

Das erste Material ist dabei ein Material mit hoher Wärmeleitfähigkeit bzw. niedrigem Wärmewiderstand bzw. niedrigem thermischem Widerstand (insbesondere Kupfer, jedoch nicht darauf beschränkt). Die Kühlkanäle können dabei vorzugsweise so ausgestaltet sein, dass sie noch oben hin offen sind, also noch abgedeckt werden müssen, damit sich ein geschlossenes Kühlsystem bildet.

In einem weiteren Schritt wird eine erste Schicht eines zweiten Materials (insbesondere Aluminium, jedoch nicht darauf beschränkt) auf eine Oberfläche der Kühlkanäle aufgebracht. Das zweite Material ist dabei vorzugsweise so ausgestaltet, dass es als Korrosionsschutz für das erste Material dient. Das Aufbringen des zweiten Materials wird dabei vorzugsweise durch ein Kaltgasspritzverfahren aufgebracht (im Englischen "cold-spray").

In einem weiteren Schritt wird ein Füllstoff in die Kühlkanäle eingebracht, sodass dieser als Stützmaterial für eine zweite Schicht (112) dient. In anderen Worten wird der Füllstoff aus einem dritten Material so in die Kühlkanäle eingebracht bzw. auf die erste Schicht aufgebracht, dass die offenen Kühlkanäle gefüllt werden. Das als Füllmaterial dienende dritte Material ist dabei vorzugsweise so ausgestaltet, dass es später leicht wieder entfernt werden kann. Das dritte Material ist dabei insbesondere ein Kunststoff, jedoch nicht darauf beschränkt. Das Aufbringen des dritten Materials erfolgt vorzugsweise in schmelzflüssiger Form oder durch ein 3D-Druckverfahren. Zum Aufbringen der zweiten Schicht kann also der Füllstoff in die Kühlkanäle gefüllt werden. Damit sich ein geschlossener Kanal aus erster Schicht und zweiter Schicht bilden kann, wird der Füllstoff innerhalb der ersten Schicht angeordnet. Der Füllstoff dient dabei zur Abstützung der zweiten Schicht, die zweite Schicht wird anschließend auf den Füllstoff aufgebracht.

Der Füllstoff ist dabei derart in den Kühlkanälen angeordnet bzw. auf der ersten Schicht aufzubringen, dass ein geschlossener Kanal aus erster Schicht und zweiter Schicht entstehen kann. Der Füllstoff kann dabei vorzugsweise als wasserlöslicher Füllstoff ausgebildet sein. Es können aber ebenso mit anderen Lösungsmitteln lösliche Füllstoffe verwendet werden. Vorzugsweise kommen Kunststoffe als Füllstoff zum Einsatz. Diese können besonders vorteilhaft in schmelzflüssiger Form auf- bzw. eingebracht werden. Der Füllstoff wird vor der ersten Benutzung des Kühlkörpers entfernt. Es muss sich dabei nicht unbedingt um einen löslichen Füllstoff handeln, es kann sich dabei auch um einen Füllstoff handeln, der mittels einer Flüssigkeit oder eines Gases ausgespült oder mittels Temperierung ausgebrannt oder wieder verflüssigt und ausgespült werden kann.

In einem weiteren Schritt wird eine zweite Schicht des zweiten Materials so aufgebracht, dass sich ein oder mehrere geschlossene Kanäle aus der ersten und der zweiten Schicht in den Kühlkanälen bilden. Das Aufbringen der zweiten Schicht wird vorzugsweise mit einem Kaltgasspritzverfahren durchgeführt.

In einem weiteren Schritt wird eine Deckschicht auf die geschlossenen Kanäle aufgebracht. Die Deckschicht kann dabei wieder aus dem ersten Material bestehen und besonders gute Wärmeleiteigenschaften aufweisen. Die Deckschicht kann dabei aus einem nicht korrosionsbeständigen Material sein, da das zweite Material in sich geschlossene Kanäle bildet und so den Grundkörper und die Deckschicht schützt. So entsteht ein Kühlkörper, der die positiven Eigenschaften des ersten Materials bezüglich Wärmeleitung und die positiven Eigenschaften des zweiten Materials bezüglich Korrosion aufweist.

Die Deckschicht ist dabei eine Schicht, die aus einem besonders gut wärmeleitenden Material, wie beispielsweise dem ersten Material, also z. B. Kupfer, aufgebaut werden kann. Die Deckschicht kann dabei mit additiven Fertigungsverfahren wie z. B. einem Cold-Spray-Verfahren aufgebracht werden.

Der Grundkörper kann beispielsweise aus dem Vollen gefräst werden oder mit anderen, z.B. ur- bzw. umformenden Verfahren bereitgestellt werden.

In einer besonders vorteilhaften Ausführungsform dient das zweite Material als Korrosionsschutz für das erste Material. Dies kann beispielsweise durch Aluminium als zweites Material geschehen, das eine Passivierungsschicht bei Kontakt mit Sauerstoff bildet.

In einer weiteren Ausführungsform ist oder wird der Füllstoff mit einer Vermittlerschicht versehen. Dies verbessert das anhaften bzw. den Aufbau der zweiten Schicht. Die Vermittlerschicht ist dabei insbesondere an der Oberfläche des Füllstoffes vorgesehen.

In einer weiteren vorteilhaften Ausführungsform ist das erste Material Kupfer oder eine Kupferlegierung. Weiterhin kann das zweite Material Aluminium oder eine Aluminiumlegierung sein. Eine Kombination der beiden Materialien bietet bezüglich des Kupfers eine fast ideale Wärmeleitfähigkeit und bezüglich des Aluminiums eine sehr gute Korrosionsbeständigkeit, sodass stark korrosive Kühlmittel wie beispielsweise deionisiertes Wasser verwendet werden können.

In einer weiteren vorteilhaften Ausführungsform umfasst das Verfahren das Bearbeiten der ersten Schicht, sodass überschüssiges zweites Material entfernt wird. Ergänzend oder alternativ kann die erste Schicht auch auf ein definiertes Maß bearbeitet werden. Dies kann durch Überfräsen geschehen, sodass die erste Schicht eine definierte Dicke im Kühlkanal aufweist. Weitere Bearbeitungsschritte können dabei das Glätten, das Ausgleichen und eine Oberflächenbehandlung sein, sodass die zweite Schicht besser anhaftet.

In einer weiteren Ausführungsform sieht das Verfahren einen Schritt Glätten der zweiten Schicht vor. Das Glätten dient dabei vordergründig dem Zweck, dass die zweite Schicht bündig mit dem Grundkörper abschließt, sodass z. B. eine Deckschicht bündig aufgebracht werden kann. Das Glätten der zweiten Schicht kann natürlich erst dann vorgesehen sein, wenn die zweite Schicht bereits aufgebracht wurde. Es ist möglich, dass die zweite Schicht ohne weitere Nachbehandlung direkt mit einer Deckschicht abgedeckt wird.

In einem weiteren Schritt wird die Deckschicht geglättet. Dies kann durch entsprechende spanende Bearbeitung, wie beispielsweise Fräsen oder durch Schleifprozesse durchgeführt werden.

In einer weiteren Ausführungsform wird das zweite Material zumindest teilweise mittels eines Kaltgasspritzverfahrens aufgebracht. Die Schritte des Aufbringens können also vollständig, teilweise und/oder abschnittsweise mittels eines Kaltgasspritzverfahrens (im Englischen "Cold-Spray"-Verfahren) durchgeführt. So kann die erste und die zweite Schicht mit einem Cold-Spray-Verfahren aufgebracht werden, ebenso kann die Deckschicht mittels eines Cold-Spray-Verfahrens aufgebracht werden. Das Aufbringen, insbesondere der ersten und der zweiten Schicht, mittels eines Cold-Spray-Verfahrens hat sich als besonders vorteilhaft erwiesen, da die erreichte Oberflächengüte und Korrosionsbeständigkeit besonders hoch ist und die Prozesskosten niedrig gehalten werden können.

In einer weiteren Ausführungsform weisen die Kühlkanäle im Querschnitt eine sich verjüngende Form auf. Die sich verjüngende Form kann sich dabei nur über Teile der Kühlkanäle erstrecken. Insbesondere hat sich eine Trichterform als vorteilhaft erwiesen. Von der Öffnung des Kühlkanals in Richtung Boden des Kühlkanals verjüngend hat den Vorteil, dass die Seitenflächen und der Boden der Kühlkanäle besonders gut für die Beschichtung mit dem zweiten Material erreichbar sind.

Die Aufgabe wird weiterhin durch einen Kühlkörper gelöst, der einen Grundkörper aus einem ersten Material aufweist. Der Grundkörper weist dabei einen oder mehrere Kühlkanäle auf. Die Kühlkanäle weisen weiterhin jeweils zumindest einen geschlossenen Kanal aus einem zweiten Material auf. Der geschlossene Kanal weist eine erste Schicht und eine zweite Schicht auf.

Weiterhin vorteilhaft ist ein Kühlkörper, der mit dem Verfahren gemäß einer der vorstehenden Ausführungsformen hergestellt wurde.
Im Folgenden wird die Erfindung anhand der in den Figuren dargestellten Ausführungsbeispiele näher beschrieben und erläutert. Es zeigen:
- FIG 1: einen Kühlkörper,
- FIG 2: einen Grundkörper,
- FIG 3: ein Aufbringen einer ersten Schicht,
- FIG 4: ein Bearbeiten der ersten Schicht
- FIG 5: einen Grundkörper mit Füllstoffen
- FIG 6: ein Aufbringen einer zweiten Schicht,
- FIG 7: einen Kühlkörper in einer weiteren Ausführungsform,
- FIG 8: ein Glätten der zweiten Schicht und
- FIG 9: verschiedene Querschnitte der Kühlkanäle.

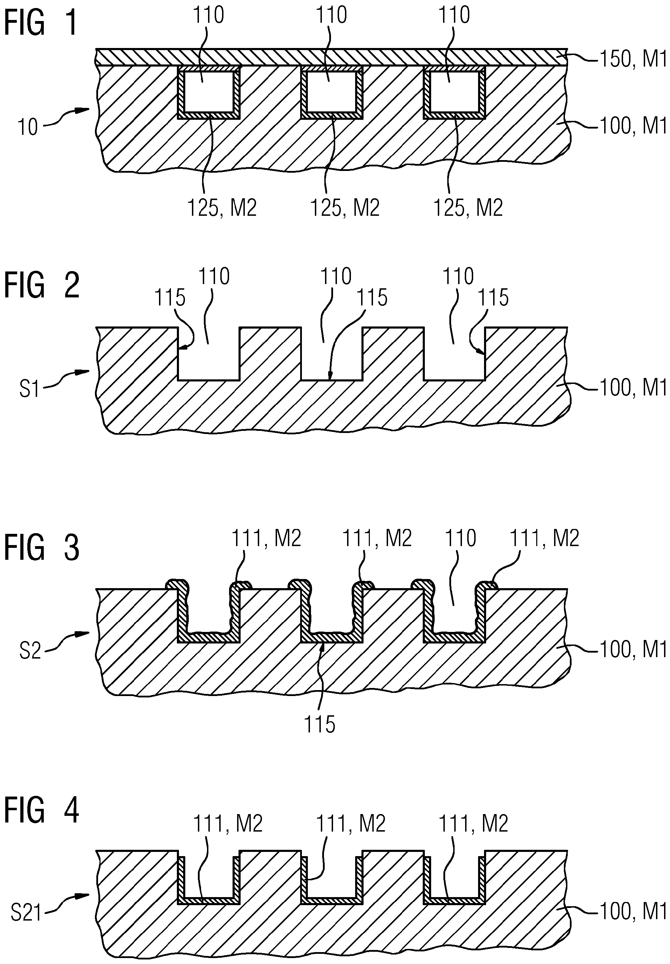

FIG 1 zeigt einen Kühlkörper 10 für einen Leistungshalbleiter, insbesondere für Thyristoren. Der Kühlkörper 10 weist dabei einen Grundkörper 100 aus einem ersten Material M1 und Kühlkanäle 110 auf. Die Kühlkanäle 110 weisen jeweils geschlossene Kanäle 125 auf, die die Wände der Kühlkanäle vom Innenraum der geschlossenen Kanäle 125 isolieren und damit vor Korrosion schützen. Dazu können die geschlossenen Kanäle 125 aus einem korrosionsbeständigen Material bestehen. Aluminium ist hier besonders vorteilhaft. Dadurch ist es möglich, dass der Grundkörper ein thermisch besonders gut leitendes Material ist, das nicht resistent gegenüber korrosiven Kühlflüssigkeiten ist. Kupfer oder eine Kupferlegierung ist als erstes Material M1 besonders gut geeignet. Eine Deckschicht 150, die ebenfalls aus dem ersten Material M1 aufgebaut ist, deckt die Kühlkanäle 110, deren geschlossenen Kanäle 125 sowie den Grundkörper 100 ab. Die Deckschicht 150 kann dabei als Kontaktfläche zu einem zu kühlenden Leistungshalbleiter dienen. Die Deckschicht 150 und der Grundkörper 100 können je nach Anwendung auch aus verschiedenen Materialien gefertigt sein.

FIG 2 zeigt einen Grundkörper 100 aus einem ersten Material M1 im Rohzustand. Der Grundkörper weist dabei Vertiefungen auf, die als Kühlkanäle 110 ausgestaltet sind. Diese sind nach oben offen und sind somit einfach zu produzieren. Die Kühlkanäle 110 weisen jeweils eine Oberfläche 115 auf, die gegen Korrosion geschützt werden soll, da in den Kühlkanälen 110 im laufenden Betrieb potentiell korrosive Kühlflüssigkeit fließt. Das Bereitstellen S1 des Grundkörpers 100 kann dabei durch Fertigteile, durch spanende Bearbeitung aus dem Vollen oder durch weitere Fertigungsverfahren geschehen. Es ist ebenso denkbar, einen Grundkörper 100 additiv zu fertigen.

FIG 3 zeigt das Aufbringen S2 einer ersten Schicht 111 aus einem zweiten Material M2 auf die Oberfläche 115 der Kühlkanäle 110. Das Aufbringen S2 wird dabei vorzugsweise mit einem Cold-Spray-Verfahren durchgeführt. Die so entstehende Schicht ist besonders günstig herzustellen und weist eine hohe Korrosionsbeständigkeit auf.

FIG 4 zeigt einen Schritt des Bearbeitens S21 der ersten Schicht 111. Die bisher ungleichmäßige Oberfläche der ersten Schicht 111, wie sie in FIG 3 zu sehen war, wird auf ein definiertes Maß und eine glatte Oberfläche gefräst. Dies stellt eine gute Ausgangsbasis für die weitere Bearbeitung dar bzw. ist bereits der Endzustand für den unteren Teil der ersten Schicht in den Kühlkanälen 110. Das Bearbeiten S21 kann übersprungen werden, wenn die erste Schicht 111 durch das Aufbringen S2 den Anforderungen an die Oberflächenbeschaffenheit der geschlossenen Kanäle 125 bereits von sich aus genügt. Die erste Schicht 111 wird also durch den Schritt Bearbeiten S21 so bearbeitet, dass die Oberflächen maßhaltig sind und dass die überflüssigen Materialien der ersten Schicht 111 entfernt worden sind. Die erste Schicht 111 besteht aus einem zweiten Material M2, das als Korrosionsschutz für den Grundkörper 100 dient.

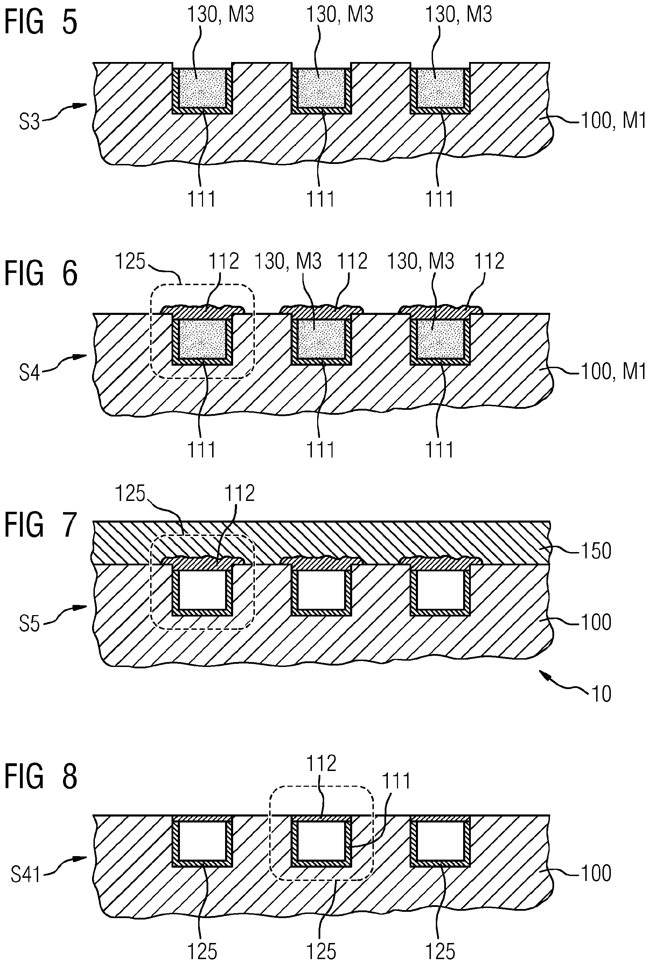

FIG 5 zeigt einen Grundkörper 100 mit einer bearbeiteten ersten Schicht 111 wie er aus FIG 4 bekannt ist. Durch einen Schritt des Einbringens S3 sind die Kühlkanäle sind nun mit einem Füllstoff 130 aus einem dritten Material M3 gefüllt worden, der als Stützmaterial dient, um eine zweite Schicht 112 aufzubringen. Das dritte Material M3 kann dabei z. B. als wasserlöslicher Kunststoff ausgebildet sein.

FIG 6 zeigt das Aufbringen S4 einer zweiten Schicht 112 auf den Füllstoff 130 sowie die erste Schicht 111, sodass sich ein geschlossener Kanal 125 bildet. Zu diesem Zweck kann der Füllstoff zuvor mit einer Vermittlerschicht (nicht dargestellt) versehen werden, die beispielsweise auf Silber, Aluminium, Antimon, Magnesium, Zinn, Zink, Blei, Tantal oder aus einer Mischung und/oder aus mindestens einer Legierung davon basiert. Optional weist die Vermittlerschicht zusätzliche Füllstoffe, wie beispielsweise einen keramischen Werkstoff, auf.

Der geschlossene Kanal 125 schützt den Grundkörper vor Korrosion und umschließt in diesem Fall den Füllstoff 130. Es ist ebenso denkbar, dass mittels additiver Fertigungsverfahren die zweite Schicht 112 ohne Füllstoff 130 aufgebracht wird.

FIG 7 zeigt einen Kühlkörper 10, wobei eine Deckschicht 150 auf den Grundkörper 100 sowie auf die geschlossenen Kanäle 125 bzw. die Kühlkanäle 110 in einem Schritt Aufbringen S5 aufgebracht wurde. Die Oberfläche der zweiten Schicht 112 wurde in diesem Fall, z. B. im Vergleich zu FIG 1, nicht oder nur geringfügig nachbearbeitet. Der Schritt des Glättens der Deckschicht 150 kann mit vollendetem Aufbringen S5 der Deckschicht 150 durchgeführt werden, unabhängig davon ob die zweite Schicht 112 geglättet wurde.

FIG 8 zeigt einen Schritt Glätten S41 der zweiten Schicht 112. Die zweite Schicht ist somit bündig mit dem Grundkörper 100. Nun kann eine Deckschicht 150 mit hoher Güte aufgebracht werden, um den aus FIG 1 bekannten Kühlkörper 10 zu erhalten. Das Glätten S41 kann durch bekannte Verfahren, z.B. spanende Verfahren durchgeführt werden. Ist eine besonders hohe Oberflächengüte gefordert, so können anschließend noch Schleifprozesse vorgesehen werden.

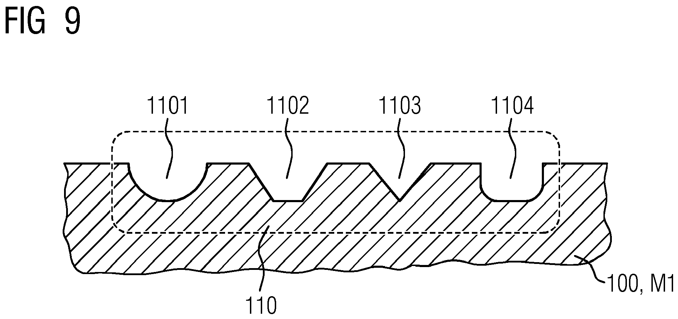

FIG 9 zeigt einen Grundkörper 100 aus einem ersten Material M1 mit unterschiedlich ausgeprägten Kühlkanälen 110. Die Kühlkanäle weisen jeweils einen sich verjüngenden Querschnitt 1101, 1102, 1103, 1104 auf und haben von links nach rechts einen runden Querschnitt 1101, einen trichterförmigen Querschnitt 1102, einen spitz zulaufenden Querschnitt 1103 und einen Querschnitt 1104 mit abgerundeten Kanten und einem flachen Boden.

Zusammenfassend betrifft die Erfindung ein Verfahren zum Herstellen eines Kühlkörpers 10 und einen Kühlkörper 10. Um einen Kühlkörper 10 aus einem thermisch sowie elektrisch gut leitenden Material M1 zu fertigen und gleichzeitig eine ausreichende Korrosionsbeständigkeit sicherzustellen werden die Schritte vorgeschlagen:
- Bereitstellen S1 eines Grundkörpers 100 aus einem ersten Material M1 aufweisend ein oder mehrere Kühlkanäle 110,
- Aufbringen S2 einer ersten Schicht 111 eines zweiten Materials M2 auf eine Oberfläche 115 der Kühlkanäle 110,
- Einbringen S3 eines Füllstoffs 130, sodass dieser als Stützmaterial für eine zweite Schicht 112 dient,
- Aufbringen S4 der zweiten Schicht 112 des zweiten Materials M2, sodass sich ein oder mehrere geschlossene Kanäle 125 aus der ersten Schicht 111 und der zweiten Schicht 112 in den Kühlkanälen 110 bilden und
- Aufbringen S5 einer Deckschicht 150 auf die geschlossenen Kanäle 125.

Die Schritte S1,...,S5 können dabei in der gezeigten Reihenfolge durchgeführt werden, es ist aber möglich, dass einzelne Schritte zusammengefasst oder an einer anderen Stelle ausgeführt werden.

### Bezugszeichenliste:

- 10: Kühlkörper
- 100: Grundkörper
- 110: Kühlkanäle
- 111: Erste Schicht
- 112: Zweite Schicht
- 115: Oberfläche
- 125: geschlossene Kanäle
- 130: Füllstoff
- 150: Deckschicht
- S1: Bereitstellen
- S2: Aufbringen einer ersten Schicht
- S3: Einbringen eines Füllstoffs
- S4: Aufbringen einer zweiten Schicht
- S5: Aufbringen einer Deckschicht
- S21: Bearbeiten der ersten Schicht
- S41: Glätten der zweiten Schicht
- M1: erstes Material
- M2: zweites Material
- M3: drittes Material

## Patentansprüche

1. Verfahren zum Herstellen eines Kühlkörpers (10) umfassend die Schritte:
- Bereitstellen (S1) eines Grundkörpers (100) aus einem ersten Material (M1) aufweisend ein oder mehrere Kühlkanäle (110),
- Aufbringen (S2) einer ersten Schicht (111) eines zweiten Materials (M2) auf eine Oberfläche (115) der Kühlkanäle (110),
- Einbringen (S3) eines Füllstoffs (130), sodass dieser als Stützmaterial für eine zweite Schicht (112) dient,
- Aufbringen (S4) der zweiten Schicht (112) des zweiten Materials (M2), sodass sich ein oder mehrere geschlossene Kanäle (125) aus der ersten Schicht (111) und der zweiten Schicht (112) in den Kühlkanälen (110) bilden,
- Aufbringen (S5) einer Deckschicht (150) auf die geschlossenen Kanäle (125).

2. Verfahren nach Anspruch 1, wobei das zweite Material (M2) als Korrosionsschutz für das erste Material (M1) dient.

3. Verfahren nach einem der vorhergehenden Ansprüche, wobei das erste Material (M1) Kupfer oder eine Kupferlegierung ist.

4. Verfahren nach einem der vorhergehenden Ansprüche, wobei das zweite Material (M2) Aluminium oder eine Aluminiumlegierung ist.

5. Verfahren nach einem der vorhergehenden Ansprüche, wobei der Füllstoff (130) mit einer Vermittlerschicht versehen ist oder wird.

6. Verfahren nach einem der vorhergehenden Ansprüche, ferner umfassend den Schritt: Bearbeiten (S21) der ersten Schicht (111), sodass überschüssiges zweites Material (M2) entfernt wird und/oder sodass die erste Schicht (111) ein definiertes Maß aufweist.

7. Verfahren nach einem der vorhergehenden Ansprüche, ferner umfassend den Schritt: Glätten (S41) der zweiten Schicht (112), sodass die zweite Schicht (112) bündig mit dem Grundkörper (100) abschließt.

8. Verfahren nach einem der vorhergehenden Ansprüche, ferner umfassend das Glätten der Deckschicht (150).

9. Verfahren nach einem der vorhergehenden Ansprüche, wobei das zweite Material (M2) zumindest teilweise mittels eines Kaltgasspritzverfahrens aufgebracht wird.

10. Verfahren nach einem der vorhergehenden Ansprüche, wobei die Kühlkanäle (110) im Querschnitt eine sich verjüngende Form, insbesondere eine Trichterform, aufweisen.

11. Kühlkörper (10) aufweisend einen Grundkörper (100) aus einem ersten Material sowie einem oder mehreren Kühlkanälen (110), wobei die Kühlkanäle (110) einen geschlossenen Kanal (125) aus einem zweiten Material (M2) aufweisen, wobei der geschlossene Kanal (125) eine erste Schicht (111) und eine zweiten Schicht (112) aufweist.
